# EUROPEAN PATENT APPLICATION

(11) **EP 1 469 354 A1**
(43) Date of publication of application: **20.10.2004**
(21) Application number: 02805900.4
(22) Date of filing: 26.12.2002
(51) Int. Cl.: G03F 7/40, H01L 21/027

(54) **COATING MATERIAL FOR PATTERN FINENESS ENHANCEMENT AND METHOD OF FORMING FINE PATTERN WITH THE SAME**

(30) Priority: 27.12.2001 JP 2001397569
(71) Applicant: TOKYO OHKA KOGYO CO., LTD., Kawasaki-shi Kanagawa 211-0012 (JP)
(72) Inventor: SHINBORI, Hiroshi, Kawasaki-shi, Kanagawa 210-0924 (JP); SUGETA, Yoshiki, Yokohama-shi, Kanagawa 234-0055 (JP)
(74) Representative: HOFFMANN - EITLE
(86) International application number: PCT/JP2002/013601
(87) International publication number: WO 2003/056393

(57) **Abstract**

It is disclosed an over-coating agent for forming fine patterns which is applied to cover a substrate having photoresist patterns thereon and allowed to shrink under heat so that the spacing between adjacent photoresist patterns is lessened, with the applied film of the over-coating agent being removed substantially completely to form fine patterns, further characterized by containing (a) a water-soluble polymer and (b) a water-soluble crosslinking agent having at least one nitrogen atom in its structure. Also disclosed is a method of forming fine-line patterns using the over-coating agent. According to the invention, one can obtain fine-line patterns which exhibit good profiles while satisfying the characteristics required of semiconductor devices, being excellent in controlling the dimension of patterns.

## Description

### Technical Field

This invention relates to an over-coating agent for forming fine patterns in the field of photolithographic technology and a method of forming fine-line patterns using such agent. More particularly, the invention relates to an over-coating agent for forming or defining fine-line patterns, such as hole patterns and trench patterns, that can meet to-day's requirements for higher packing densities and smaller sizes of semiconductor devices.

### Background Art

In the manufacture of electronic components such as semiconductor devices and liquid-crystal devices, there is employed the photolithographic technology which, in order to perform a treatment such as etching on the substrate, first forms a film (photoresist layer) over the substrate using a so-called radiation-sensitive photoresist composition which is sensitive to activating radiations, then performs exposure of the film by selective illumination with an activating radiation, performs development to dissolve away the photoresist layer selectively to form an image pattern (photoresist pattern), and forms a variety of patterns Including contact providing patterns such as a hole pattern and a trench pattern using the photoresist pattern as a protective layer (mask pattern).

With the recent increase in the need for higher packing densities and smaller sizes of semiconductor devices, increasing efforts are being made to form sufficiently fine-line patterns and submicron-electronic fabrication capable of forming patterns with linewidths of no more than 0.20 µm is currently required. As for the activating light rays necessary in the formation of mask patterns, short-wavelength radiations such as KrF, ArF and F₂ excimer laser beams and electron beams are employed. Further, active R&D efforts are being made to find photoresist materials as mask pattern formers that have physical properties adapted to those short-wavelength radiations.

In addition to those approaches for realizing submicron-electronic fabrication which are based on photoresist materials, from view point of an increase in a photoresist material life by making improvements to processes of forming patterns using existing photoresist materials, active R&D efforts are also being made on the basis of pattern forming method with a view to finding a technology that can provide higher resolutions than those possessed by photoresist materials.

For example, JP-5-166717A discloses a method of forming fine patterns which comprises the steps of defining patterns (=photoresist-uncovered patterns) into a pattern-forming resist on a substrate, then coating over entirely the substrate with a mixing generating resist that is to be mixed with said pattern-forming resist, baking the assembly to form a mixing layer on both sidewalls and the top of the pattern-forming resist, and removing the non-mixing portions of said mixing generating resist such that the feature size of the photoresist-uncovered pattern is reduced by an amount comparable to the dimension of said mixing layer. JP-5-241348 discloses a pattern forming method comprising the steps of depositing a resin, which becomes insoluble in the presence of an acid, on a substrate having formed thereon a resist pattern containing an acid generator, heat treating the assembly so that the acid is diffused from the resist pattern into said resin insoluble in the presence of an acid to form a given thickness of insolubilized portion of the resist near the interface between the resin and the resist pattern, and developing the resist to remove the resin portion through which no acid has been diffused, thereby ensuring that the feature size of the pattern is reduced by an amount comparable to the dimension of said given thickness.

However, in these methods, it is difficult to control the thickness of layers to be formed on the sidewalls of resist patterns. In addition, the in-plane heat dependency of wafers is as great as ten-odd nanometers per degree Celsius, so it is extremely difficult to keep the in-plane uniformity of wafers by means of the heater employed in current fabrication of semiconductor devices and this leads to the problem of occurrence of significant variations in pattern dimensions. Furthermore, defects (in patterns) due to the formation of the mixing layer are apt to occur, and that these problems are quite difficult to solve.

Another approach known to be capable of reducing pattern dimensions is by fluidizing resist patterns through heat treatment and the like. For example, JP-1-307228A discloses a method comprising the steps of forming a resist pattern on a substrate and applying heat treatment to deform the cross-sectional shape of the resist pattern, thereby defining a fine pattern. In addition, JP-4-364021A discloses a method comprising the steps of forming a resist pattern and heating it at around its softening temperature to fluidize the resist pattern, thereby changing the dimensions of its resist pattern to form or define a fine-line pattern.

In these methods, the wafer's in-plane heat dependency is only a few nanometers per degree Celsius and is not very problematic. On the other hand, it is difficult to control the resist deformation and fluidizing on account of heat treatment, so it is not easy to provide a uniform resist pattern in a wafer's plane.

An evolved version of those methods is disclosed in JP-7-45510A and it comprises the steps of forming a resist pattern on a substrate, forming a stopper resin on the substrate to prevent excessive thermal fluidizing of the resist pattern, then applying heat treatment to fluidize the resist so as to change the dimensions of its pattern, and thereafter removing the stopper resin to form or define a fine-line pattern. As the stopper resin, specifically, polyvinyl alcohol is employed. However, polyvinyl alcohol is not highly soluble in water and cannot be readily removed completely by washing with water, introducing difficulty in forming a pattern of good profile. The pattern formed is not completely satisfactory in terms of stability over time.

JP 2001-281886A discloses a method comprising the steps of covering a surface of a resist pattern with an acidic film made of a resist pattern size reducing material containing a water-soluble resin, rendering the surface layer of the resist pattern alkali-soluble, then removing said surface layer and the acidic film with an alkaline solution to reduce the feature size of the resist pattern. JP-2002-184673A discloses a method comprising the steps of forming a resist pattern on a substrate, then forming a film containing a water-soluble film forming component on said resist pattern, heat treating said resist pattern and film, and immersing the assembly in an aqueous solution of tetramethylammonium hydroxide, thereby forming a fine-line resist pattern without involving a dry etching step. However, both methods are simply directed to reducing the size of resist trace patterns themselves and therefore are totally different from the present invention in object.

### Disclosure of Invention

The present invention aims at providing an over-coating agent which makes it possible, particularly in the case of forming fine patterns with the use of an over-coating agent, to achieve a favorable ability to control pattern dimensions so as to provide fine patterns while sustaining the focus margin and give fine-line patterns that have a satisfactory profile and satisfy the characteristics required in semiconductor devices, and a method of forming fine patterns using the same.

In order to solve the above-described problems, the present Invention provides an over-coating agent for forming fine patterns which is applied to cover a substrate having photoresist patterns thereon and allowed to shrink under heat so that the spacing between adjacent photoresist patterns is lessened, with the applied film of the over-coating agent being removed substantially completely to form fine patterns, further characterized by containing (a) a water-soluble polymer and (b) a water-soluble crosslinking agent having at least one nitrogen atom in its structure.

In a preferred embodiment, component (a) is at least one member selected from among acrylic polymers, vinyl polymers and cellulosic polymers.

In a preferred embodiment, component (b) is at least one member selected from among triazine derivatives, glycoluril derivatives and urea derivatives.

The present invention further provides a method of forming fine-line patterns which comprises coating a substrate having photoresist patterns with the above-described over-coating agent for forming fine-line patterns, applying a heat treatment to cause thermal shrinkage of the over-coating agent, thus lessening the spacing between adjacent photoresist patterns by the resulting thermal shrinkage action, and then substantially completely removing the over-coating agent for forming fine-line patterns.

In a preferred embodiment, the heat treatment is performed by heating the substrate at a temperature that does not cause thermal fluidizing of the photoresist patterns on the substrate.

### Best Mode for Carrying Out the Invention

The over-coating agent of the invention for forming fine features of patterns is used to be applied to cover a substrate, having photoresist patterns (mask patterns) thereon, including patterns typified by hole patterns or trench patterns, each of these patterns are defined by spacing between adjacent photoresist patterns (mask patterns). Upon heating, the applied film of over-coating agent shrinks to increase the width of each of the photoresist patterns, thereby narrowing or lessening adjacent hole patterns or trench patterns as defined by spacing between the photoresist patterns and, thereafter, the applied film is removed substantially completely to form or define fine patterns.

The phrase "removing the applied film substantially completely" as used herein means that after lessening the spacing between adjacent photoresist patterns by the heat shrinking action of the applied over-coating agent, said film is removed in such a way that no significant thickness of the over-coating agent will remain at the Interface with the photoresist patterns. Therefore, the present invention does not include methods in which a certain thickness of the over-coating agent is left Intact near the interface with the photoresist pattern so that the feature size of the pattern is reduced by an amount corresponding to the residual thickness of the over-coating agent.

The over-coating agent of the invention for forming fine patterns contains (a) a water-soluble polymer and (b) a water-soluble crosslinking agent having at least one nitrogen atom in its structure.

The water-soluble polymer as component (a) may be any polymer that can dissolve in water at room temperature and various types may be employed without particular limitation: preferred examples Include acrylic polymers, vinyl polymers and cellulosic polymers.

Exemplary acrylic polymers include polymers and copolymers having monomeric components, such as acrylic acid, methyl acrylate, methacrylic acid, methyl methacrylate, N,N-dimethylacrylamide, N,N-dimethylaminopropylmethacrylamide, N,N-dimethylaminopropylacrylamide. N-methylacrylamide, diacetone acrylamide. N,N-dimethylaminoethyl methacrylate, N,N-diethylaminoethyl methacrylate, N,N-dimethylaminoethyl acrylate, acryloylmorpholine, etc.

Exemplary vinyl polymers include polymers and copolymers having monomeric components, such as N-vinylpyrrolidone, vinyl imidazolidinone, vinyl acetate, etc.

Exemplary cellulosic polymers include hydroxypropylmethyl cellulose phthalate, hydroxypropylmethyl cellulose acetate phthalate, hydroxypropylmethyl cellulose hexahydrophthalate, hydroxypropylmethyl cellulose acetate succinate, hydroxypropylmethyl cellulose, hydroxypropyl cellulose, hydroxyethyl cellulose, cellulose acetate hexahydrophthalate. carboxymethyl cellulose, ethyl cellulose, methylcellulose, etc.

Among all, acrylic polymers are most preferable in view of easiness in pH adjustment. It is also preferable a copolymer of an acrylic polymer with a water-soluble polymer other than acrylic polymers (for example, a vinyl polymer or a cellulosic polymer as cited above), since such a copolymer contributes to the improvement in the efficiency of shrinking the spacing between adjacent photoresist patterns while maintaining the photoresist pattern shape during the heat treatment. Either one or more water-soluble polymers may be used as component (a).

In the case of using a copolymer as component (a), the composition ratio of the constituents of the copolymer is not particularly restricted. Considering stability over time, it is preferable to employ the acrylic polymer at a higher ratio than other constitutional polymer(s). In addition to the above-described way of using the acrylic polymer in a larger amount, it is also possible to improve the stability over time by adding an acidic compound such as p-toluenesulfonic acid or dodecylbenzenesulfonic acid.

To attain a necessary and sufficient film thickness, the content of component (a) in the over-coating agent (in terms of solid matters) of the present invention preferably ranges about 1 - 99 mas%, still preferably about 40 - 99 mass% and particularly preferably about 65 - 99 mass%.

The water-soluble orosslinking agent as component (b) has at least one nitrogen atom in its structure. As such a water-soluble crosslinking agent, it is preferable to use nitrogen-containing compounds having amino and/or imino groups in which at least two hydrogen atoms are substituted by hydroxyalkyl and/or alkoxyalkyl groups. Examples of these nitrogen-containing compounds include melamine derivatives, urea derivatives, guanamine derivatives, acetoguanamine derivatives, benzoguanamine derivatives and succinylamide derivatives in which hydrogen atoms in an amino group are substituted by a methylol group, an alkoxymethyl group or both of them, and glycoluril derivatives and ethyleneurea derivatives in which hydrogen atoms in an imino group are substituted.

These nitrogen-containing compounds can be obtained by, for example, reacting melamine derivatives, urea derivatives, guanamine derivatives, acetoguanamine derivatives, benzoguanamine derivatives. succinylamide derivatives, glycoluril derivatives, ethyleneurea derivatives, etc. with formalin in boiling water to convert into methylol-carrying compounds, optionally followed alkoxylation by reacting with lower alcohols, such as methanol, ethanol, n-propanol, isopropanol, n-butanol, isobutanol, etc.

Among these nitrogen-containing compounds, it is preferable from the viewpoint of crosslinkability to use benzoguanamine derivatives, guanamine derivatives, melamine derivatives, glycouril derivatives and urea derivatives having an amino group or an imino group in which at least two hydrogen atoms are substituted by a methylol group, a (lower alkoxy) methyl group or both of them. It is particularly preferable to use triazine derivatives, such as benzoguanamine derivatives, guanamine derivatives or melamine derivatives. It is still preferable that these triazine derivatives have 3 or more but less than 6 methylol or (lower alkoxy) methyl groups on average per triazine ring.

Specific examples of such nitrogen-containing compounds include benzoguanamine derivatives, such as methoxymethylated benzoguanamine having 3.7 methoxymethyl groups on average per triazine ring which is marketed under the trade name "MX-750", benzoguanamine which is marketed under the trade name "SB-203" and isobutoxymethylated benzoguanamine which is marketed under the trade name "BX-55H" (each product of Sanwa Chemical Co., Ltd.) and methoxymethylated ethoxymethylated benzoguanamine which is marketed under the trade name "Cymel 1125" (product of Mitsui Cyanamid Co.) and melamine derivatives such as methoxymethylated melamine which is marketed under the trade name "MX-788" (product of Sanwa Chemical Co., Ltd.) and methoxymethylated isobutoxymethylated melamine which is marketed under the trade name "Cymel 1141" (product of Mitsui Cyanamid Co.). As examples of the glycoluril derivatives, methylol glycoluril which is marketed under the trade name "Cymel 1172" (product of Mitsui Cyanamid Co.), etc. may be cited.

The content of component (b) in the over-coating agent (in terms of solid matters) of the present invention preferably ranges about 1 - 99 mass%, still preferably about 1 - 60 mass% and particularly preferably about 1 - 35 mass%.

The over-coating agent of the invention for forming fine patterns is preferably used as an aqueous solution at a concentration of 3 - 50 mass%, more preferably at 5 - 20 mass%. If the concentration of the aqueous solution is less than 3 mass%, poor coverage of the substrate may result. If the concentration of the aqueous solution exceeds 50 mass%, there is no appreciable improvement in the intended effect that justifies the increased concentration and the solution cannot be handled efficiently.

As already mentioned, the over-coating agent of the invention for forming fine patterns is usually employed as an aqueous solution using water as the solvent. A mixed solvent system comprising water and an alcoholic solvent may also be employed. Exemplary alcoholic solvents include methyl alcohol, ethyl alcohol, propyl alcohol, isopropyl alcohol, glycerol, ethylene glycol, propylene glycol, 1,2-butylene glycol, 1,3-buthylene glycol, and 2,3-buthylene glycol, etc. These alcoholic solvents are mixed with water in amounts not exceeding about 30 mass%.

In addition to components (a) and (b), the over-coating agent for forming fine patters of the present invention may optionally contain water-soluble amines and surfactants.

Exemplary water-soluble amines include amines having pKa (acid dissociation constant) values of 7.5 - 13 in aqueous solution at 25 °C. Specific examples include the following: alkanolamines, such as monoethanolamine, diethanolamine, triethanolamine, 2-(2-aminoethoxy)ethanol, N,N-dimethylethanolamine, N,N-diethylethanolamine, N,N-dibutylethanolamine, N-methylethanoZamine, N-ethylethanolamine, N-butylethanolamine, N-methyldiethanolamine, monoisopropanolamine, diisopropanolamine and triisopropanolamine; polyalkylenepolyamines, such as diethylenetriamine, triethylenetetramine, propylenediamine, N,N-diethylethylenediamine, 1,4-butanediamine. N-ethylethylenediamine, 1,2-propanediamine, 1,3-propanediamine and 1,6-hexanediamine; aliphatic amines, such as triethylamine, 2-ethyl-hexylamine, dioatylamine, tributylamine, tripropylamine, triallylamine. heptylamine and cyclohexylamine: aromatic amines such as benzylamine and diphenylamine; and cyclic amines, such as piperazine, N-methyl-piperazine and hydroxyethylpiperazine. Preferred water-soluble amines are those having boiling points of 140 °C (760 mmHg) and above, as exemplified by monoethanolamine and triethanolamine. The addition of water-soluble amines is effective in view of preventing the occurrence of impurities and adjusting pH values.

If the water-soluble amine is to be added, it is preferably incorporated in an amount of about 0.1 - 30 mass%, more preferably about 2 - 15 mass%, of the over-coating agent (in terms of solids content). If the water-soluble amine is incorporated in an amount of less than 0.1 mass%, the coating fluid may deteriorate over time. If the water-soluble amine is incorporated in an amount exceeding 30 mass%, the photoresist pattern being formed may deteriorate in shape.

The surfactant is not limited to any particular types, except that it must exhibit certain characteristics such as high solubility, non-formation of a suspension and miscibility with component (a). The use of such surfactants that satisfy these characteristics can effectively prevent the generation of defects that has been problems in conventional methods, which is considered to be pertinent to miorofoaming upon applying over-coating materials on the substrate.

Suitable surfactants include N-alkylpyrrolidones. quaternary ammonium salts and phosphate esters of polyoxyethylene.

N-alkylpyrrolidones as surfactant are preferably represented by the following general formula (I): 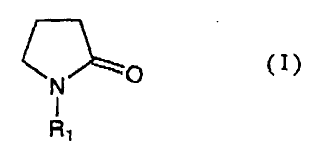 where R₁ is an alkyl group having at least 6 carbon atoms.

Specific examples of N-alkylpyrrolidones as surfactant Include N-hexyl-2-pyrrolidone, N-heptyl-2-pyrrolidone. N-octyl-2-pyrrolidone, N-nonyl-2-pyrrolidone, N-decyl-2-pyrrolidone, N-undecyl-2-pyrrolidone, N-dodecyl-2-pyrrolidone, N-tridecyl-2-pyrrolidone, N-tetradecyl-2-pyrrolidone, N-pentadecyl-2-pyrrolidone, N-hexadeoyl-2-pyrrolidone, N-heptadecyl-2-pyrrolidone and N-ootadecyl-2-pyrrolidone. Among these. N-octyl-2-pyrrolidone ("SURFADONE LP 100" of ISP Inc.) is preferably used.

Quaternary ammonium salts as surfactant are preferably represented by the following general formula (II): 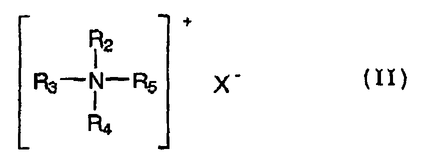 where R₂, R₃, R₄ and R₅ are each independently an alkyl group or a hydroxyalkyl group (provided that at least one of them Is an alkyl or hydroxyalkyl group having not less than 6 carbon atoms): X⁻ is a hydroxide ion or a halogenide ion.

Specific examples of quaternary ammonium salts as surfactant include dodecyltrimethylammonium hydroxide, tridecyltrimethylammonium hydroxide, tetradecyltrimethylammonium hydroxide, pentadecyltrimethylammonium hydroxide, hexadecyltrimethylammonium hydroxide, heptadecyltrimethylammonium hydroxide and octadecyltrimethylammonium hydroxide. Among these, hexadecyltrimethylammonium hydroxide is preferably used.

Phosphate esters of polyoxyethylene are preferably represented by the following general formula (III): 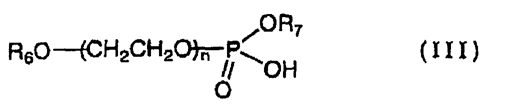 where R₆ is an alkyl or alkylaryl group having 1-10 carbon atoms; R₇ is a hydrogen atom or (CH₂CH₂O)R₆ (where R₆ is as defined above): n is an integer of 1 - 20.

To mention specific examples, phosphate esters of polyoxyethylene that can be used as surfactants are commercially available under trade names "PLYSURF A212E" and "PLYSURF A210G" from Dai-ichi Kogyo Seiyaku Co., Ltd.

The amount of the surfactant is preferably about 0.1 - 10 mass%, more preferably about 0.2 - 2 mass%, of the over-coating agent (in terms of solids content). The addition of the surfactant contributes to the improvement in coating properties, wafer's in-plane uniformity, prevention of the variations in the percent shrinkage of patterns, prevention of the occurrence of microfoaming and defects, etc.

The method of forming fine-line patterns according to the second aspect of the invention comprises the steps of covering a substrate having photoresist patterns thereon with the above-described over-coating agent for forming fine patterns, then applying heat treatment to shrink the applied over-coating agent under the action of heat so that the spacing between adjacent photoresist patterns is reduced, and subsequently removing the applied film of the over-coating agent completely.

The method of preparing the substrate having photoresist patterns thereon is not limited to any particular type and it can be prepared by conventional methods employed in the fabrication of semiconductor devices, liquid-crystal display devices, magnetic heads and microlens arrays. In an exemplary method, a photoresist composition of chemically amplifiable or other type is spin- or otherwise coated on a substrate such as a silicon wafer and dried to form a photoresist layer, which is illuminated with an activating radiation such as ultraviolet, deep-ultraviolet or excimer laser light through a desired mask pattern using a reduction-projection exposure system or subjected to electron beam photolithography. then heated and developed with a developer such as an alkaline aqueous solution, typically a 1 - 10 mass% tetramethylammonium hydroxide (TMAH) aqueous solution. thereby forming a photoresist pattern on the substrate.

The photoresist composition serving as a material from which photoresist patterns are formed is not limited in any particular way and any common photoresist compositions may be employed including those for exposure to i- or g-lines, those for exposure with an excimer laser (e.g. KrF, ArF or F₂) and those for exposure to EB (electron beams).

Among them, it is preferable to use a photoresist composition which never causes the formation of a mixing layer around the interface between the photoresist patterns and the over-coating layer of the present Invention in the case of forming the photoresist patterns. When a mixing layer is formed, there are observed undesirable phenomena such that defects are likely to arise and that the in-plane heat dependency of the substrate attains ten-odd nanometers.

In the case of using photoresist compositions for exposure to i- or g-lines (for example, positive-working photoresist compositions containing a novolac resin and a naphtoquinone diazide-type photosensitive agent), the above-described problems may never arise and thus it is unnecessary to worry about them. However, in the case of using chemical amplification photoresist compositions containing a compound which generates an acid upon light exposure (i.e., an acid generator), such as photoresist compositions for exposure to an excimer laser and photoresist compositions for exposure to EB (electron beams), it should be taken into account that a mixing layer is sometimes formed around the interface between the over-coating agent and the photoresist patterns due to the acid generated from the acid generator. The formation of the mixing layer depends on the diffusion length (diffusion distance) of the acid generated from the acid generator and the amounts of a basic substance to be added. Therefore, in the case of using a photoresist composition for exposure to an excimer laser or a photoresist composition for exposure to EB (electron beams), it is favorable to select an appropriate photoresist composition for preventing the formation of such a mixing layer as described above.

After thusly forming the photoresist pattern as a mask pattern, the over-coating agent for forming fine patterns is applied to cover entirely the substrate. After applying the over-coating agent, the substrate may optionally be pre-baked at a temperature of 60 - 150 °C for 10 - 90 seconds.

The over-coating agent may be applied by any methods commonly employed in the conventional heat flow process. Specifically, an aqueous solution of the over-coating agent for forming fine patterns is applied to the substrate by any known application methods including whirl coating with a spinner, etc.

In the next step, heat treatment is performed to cause thermal shrinkage of the film of the over-coating agent. Under the resulting force of thermal shrinkage of the film, the dimensions of the photoresist pattern in contact with the film will increase by an amount equivalent to the thermal shrinkage of the film and, as the result, the photoresist pattern widens and accordingly the spacing between the adjacent photoresist patterns lessens. The spacing between the adjacent photoresist patterns determines the diameter or width of the patterns to be finally obtained, so the decrease in the spacing between the adjacent photoresist patterns contributes to reducing the diameter of each element of hole patterns or the width of each element of trench patterns, eventually leading to the definition of a pattern with smaller feature sizes.

The heating temperature is not limited to any particular value as long as it is high enough to cause thermal shrinkage of the film of the over-coating agent and form or define a fine pattern. Heating is preferably done at a temperature that will not cause thermal fluidizing of the photoresist pattern. The temperature that will not cause thermal fluidizing of the photoresist pattern is such a temperature that when a substrate on which the photoresist pattern has been formed but no film of the over-coating agent has been formed is heated, the photoresist pattern will not experience any dimensional changes (for example, dimensional changes due to spontaneously fluidized deforming). Performing a heat treatment under such temperature conditions is very effective for various reasons, e.g. a fine-line pattern of good profile can be formed more efficiently and the duty ratio in the plane of a wafer, or the dependency on the spacing between photoresist patterns in the plane of a wafer, can be reduced. Considering the softening points of a variety of photoresist compositions employed in current photolithographic techniques, the preferred heat treatment is usually performed within a temperature range of about 80 - 160 °C for 30 - 90 seconds, provided that the temperature is not high enough to cause thermal fluidizing of the photoresist.

The thickness of the film of the over-coating agent for the formation of fine-line patterns is preferably just comparable to the height of the photoresist pattern or high enough to cover it.

In the subsequent step, the remaining film of the over-coating agent on the patterns is removed by washing with an aqueous solvent, preferably pure water, for 10 - 60 seconds. Prior to washing with water, rinsing may optionally be performed with an aqueous solution of alkali (e.g. tetramethylammonium hydroxide (TMAH) or oholine). The over-coating agent of the present invention is easy to remove by washing with water and it can be completely removed from the substrate and the photoresist pattern.

As a result, each pattern on the substrate has a smaller feature size because each pattern is defined by the narrowed spacing between the adjacent widened photoresist patterns.

The fine-line pattern thus formed using the over-coating agent of the present invention has a pattern size smaller than the resolution limit attainable by the conventional methods. In addition, it has a good enough profile and physical properties that can fully satisfy the characteristics required of semiconductor devices.

The technical field of the present Invention is not limited to the semiconductor industry and it can be employed in a wide range of applications including the fabrication of liquid-crystal display devices, the production of magnetic heads and even the manufacture of microlens arrays.

### EXAMPLES

The following examples are provided for further Illustrating the present invention but are in no way to be taken as limiting. Unless otherwise noted, all amounts of ingredients are expressed in mass%.

### EXAMPLE 1

A copolymer of acrylic acid and vinylpyrrolidone [98 g; acrylic acid/vinylpyrrolidone = 2:1 (mass ratio)] and tetra(hydroxymethyl)glycoluril (2 g) were dissolved in water (1900 g) to prepare an over-coating agent having the overall solids content adjusted to 5 mass%.

A substrate was whirl coated with a positive-acting photoresist TDMR-AR2000 (product of Tokyo Ohka Kogyo Co., Ltd.), which contain a novolac resin and a naphtoquinone diazide-type photosensitive agent, and baked at 90 °C for 90 seconds to form a photoresist layer in a thickness of 1.3 µm.

The photoresist layer was exposed with a laser exposure unit (Nikon NSR-2205i14E of Nikon Corp.), subjected to heat treatment at 110 °C for 90 seconds and developed with an aqueous solution of 2.38 mass% TMAH (tetramethylammonium hydroxide) to form photoresist patterns which defined hole patterns with an each diameter of 411.8 nm (i.e., the spacing between the photoresist patterns was 411.8 nm),

Then above-described over-coating agent was applied onto the substrate including the hole patterns and subjected to heat treatment at 120 °C for 60 seconds. Subsequently, the over-coating agent was removed completely using pure water at 23 °C. The each diameter of the hole patterns was reduced to about 231.2 nm.

### EXAMPLE 2

A copolymer of acrylic acid and vinylpyrrolidone [98 g; acrylic acid/vinylpyrrolidone = 2:1 (mass ratio)] and tetra(hydroxymethyl)glycoluril (2 g) were dissolved in water (400 g) to prepare an over-coating agent having the overall solids content adjusted to 20 mass%.

A substrate was whirl coated with an excimer laser-ready photoresist composition DP-TF010PM (product of Tokyo Ohka Kogyo Co., Ltd.), and baked at 130 °C for 150 seconds to form a photoresist layer in a thickness of 3.0 µm.

The photoresist layer was exposed with a laser exposure unit FPA3000EX3 (Canon Inc.), subjected to heat treatment at 120 °C for 150 seconds and developed with an aqueous solution of 2.38 mass% TMAH to form photoresist patterns which defined hole patterns with an each diameter of 202.2 nm (i.e., the spacing between the photoresist patterns was 202.2 nm).

Then above-described over-coating agent was applied onto the substrate including the hole patterns and subjected to heat treatment at 120 °C for 60 seconds. Subsequently, the over-coating agent was removed completely using pure water at 23 °C. The each diameter of the hole patterns was reduced to about 138.5 nm.

### EXAMPLE 3

A copolymer of acrylic acid and vinylpyrrolidone [98 g; acrylic acid/vinylpyrrolidone = 2:1 (mass ratio)] and tetra(hydroxymethyl)glycoluril (2 g) were dissolved in water (400 g) to prepare an over-coating agent having the overall solids content adjusted to 20 mass%.

A substrate was whirl coated with an electron beam-ready photoresist composition EP-TF004EL (product of Tokyo Ohka Kogyo Co., Ltd.). and baked at 150 °C for 300 seconds to form a photoresist layer in a thickness of 2.0 µm.

The photoresist layer was exposed to be traced with an electron beam (EB) lithography equipment (HL-800D of Hitachi, Ltd.), subjected to heat treatment at 140 °C for 300 seconds and developed with an aqueous solution of 2.38 mass% TMAH to form photoresist patterns which defined hole patterns with an each diameter of 234.8 nm (i.e., the spacing between the photoresist patterns was 234.8 nm).

Then above-described over-coating agent was applied onto the substrate including the hole patterns and subjected to heat treatment at 120 °C for 60 seconds. Subsequently, the over-coating agent was removed completely using pure water at 23 °C. The each diameter of the hole patterns was reduced to about 172.6 nm.

### COMPARATIVE EXAMPLE 1

Photoresist patterns were formed in the same manner as described in EXAMPLE 1, except that an aqueous solution of 5 mass% polyvinyl alcohol was used as the over-coating agent. In this case, the over-coating agent could not be removed completely in the removing step with pure water at 23 °C, and residues that were visually confirmed remained on the substrate.

### COMPARATIVE EXAMPLE 2

Photoresist patterns were formed in the same manner as described in EXAMPLE 2, except that the over-coating agent was not used. That is, as described in EXAMPLE 2, the photoresist layer on the substrate was developed with an aqueous solution of 2.38 mass% TMAH to form photoresist patterns which defined hole patterns with an each diameter of 202.2 nm. Then the substrate without being covered with the over-coating agent was subjected to heat treatment at 120 °C for 60 seconds. As a result, the each size of the hole patterns did not changed, and therefore fine-line patterns were not obtained.

### Industrial Applicability

As described above in detail, according to the present inventions of the over-coating agent for forming fine-line patterns and the method of forming fine-line patterns using the agent, one can obtain fine-line patterns which exhibit good profiles, being excellent in controlling the dimension of patterns and in removing the applied film of the over-coating agent, while satisfying the characteristics required of semiconductor devices.

## Claims

1. An over-coating agent for forming fine patterns which is applied to cover a substrate having photoresist patterns thereon and allowed to shrink under heat so that the spacing between adjacent photoresist patterns is lessened, with the applied film of the over-coating agent being removed substantially completely to form fine patterns, further **characterized by** containing (a) a water-soluble polymer and (b) a water-soluble crosslinking agent having at least one nitrogen atom in its structure.

2. The over-coating agent for forming fine patterns according to claim 1, wherein component (a) is at least one member selected from among acrylic polymers, vinyl polymers and cellulosic polymers.

3. The over-coating agent for forming fine patterns according to claim 1, wherein component (b) is at least one member selected from among triazine derivatives, glycoluril derivatives and urea derivatives.

4. The over-coating agent for forming fine patterns according to claim 1, which is an aqueous solution having a concentration of 3 - 50 mass%.

5. The over-coating agent for forming fine patterns according to claim 1, wherein the agent, in terms of solid matters, contains 1 - 99 mass% of component (a) and 1 - 99 mass% of component (b).

6. The over-coating agent for forming fine patterns according to claim 1, wherein the agent, in terms of solid matters, contains 40 - 99 mass% of component (a) and 1 - 60 mass% of component (b).

7. A method of forming fine patterns comprising the steps of covering a substrate having thereon photoresist patterns with the over-coating agent for forming fine patterns of claim 1, then applying heat treatment to shrink the applied over-coating agent under the action of heat so that the spacing between adjacent photoresist patterns is lessened, and subsequently removing the applied film of the over-coating agent substantially completely.

8. The method of forming fine patterns according to claim 7, wherein the heat treatment is performed by heating the substrate at a temperature that does not cause thermal fluidizing of the photoresist patterns on the substrate.
